# EUROPEAN PATENT APPLICATION

(11) **EP 4 287 243 A1**
(43) Date of publication of application: **06.12.2023**
(21) Application number: 21873688.2
(22) Date of filing: 04.08.2021
(51) Int. Cl.: H01L 21/60

(54) **SEMICONDUCTOR STRUCTURE AND METHOD FOR MANUFACTURING SEMICONDUCTOR STRUCTURE**

(30) Priority: 10.03.2021 CN 202110259349
(71) Applicant: Changxin Memory Technologies, Inc., Hefei, Anhui 230601 (CN)
(72) Inventor: CHANG, Chih-wei, Anhui 230601 (CN)
(74) Representative: Lavoix
(86) International application number: PCT/CN2021/110616
(87) International publication number: WO 2022/188348

(57) **Abstract**

The present application refers to the field of semiconductor technologies and proposes a semiconductor structure and a manufacturing method of a semiconductor structure. The semiconductor structure includes a first chip and a second chip. A first conductive contact pad is spaced apart from a second conductive contact pad and both of the first conductive contact pad and the second conductive contact pad are connected to a first conductive connecting line. A third conductive contact pad is spaced apart from a fourth conductive contact pad and both of the third conductive contact pad and the fourth conductive contact pad are connected to a second conductive connecting line. The first conductive contact pad and the second conductive contact pad are both in staggered connection with the third conductive contact pad, and the first conductive contact pad and the second conductive contact pad are both in staggered connection with the fourth conductive contact pad, so that a reliable electrical connection between the first conductive connecting line and the second conductive connecting line is ensured, the problem of disconnection between the first conductive connecting line and the second conductive connecting line is avoided, and the performance of the semiconductor structure is improved.

## Description

### CROSS-REFERENCE TO RELATED APPLICATION

The disclosure claims priority to Chinese patent application No. 202110259349.7, filed on March 10, 2021 and entitled "SEMICONDUCTOR STRUCTURE AND MANUFACTURING METHOD OF THE SEMICONDUCTOR STRUCTURE", the disclosure of which is hereby incorporated by reference in its entirety.

### TECHNICAL FIELD

The disclosure relates to the field of semiconductor technologies, and in particular to a semiconductor structure and a manufacturing method of the semiconductor structure.

### BACKGROUND

In the related art, bonding between chips is achieved by connecting metal pads on the chips to each other. However, due to process limitations, the problem of disconnection or short-circuit connection between two metal pads of two chips is easily caused.

### SUMMARY

The disclosure provides a semiconductor structure and a manufacturing method of the semiconductor structure, to improve the performance of the semiconductor structure.

According to a first aspect of the disclosure, a semiconductor structure is provided, including a first chip and a second chip.

The first chip includes a first substrate, a first conductive connecting line, a first conductive contact pad, and a second conductive contact pad. The first conductive contact pad is spaced apart from the second conductive contact pad and both of the first conductive contact pad and the second conductive contact pad are connected to the first conductive connecting line.

The second chip includes a second substrate, a second conductive connecting line, a third conductive contact pad, and a fourth conductive contact pad. The third conductive contact pad is spaced apart from the fourth conductive contact pad and both of the third conductive contact pad and the fourth conductive contact pad are connected to the second conductive connecting line.

The first conductive contact pad and the second conductive contact pad are both in staggered connection with the third conductive contact pad, and the first conductive contact pad and the second conductive contact pad are both in staggered connection with the fourth conductive contact pad.

According to a second aspect of the disclosure, a semiconductor structure is provided, including a substrate, a conductive connecting line, a first conductive contact pad and a second conductive contact pad.

The conductive connecting line is located in the substrate.

The first conductive contact pad is located in the substrate, connected to the conductive connecting line, and located above the conductive connecting line.

The second conductive contact pad is located in the substrate, connected to the conductive connecting line, and located above the conductive connecting line.

The first conductive contact pad is spaced apart from the second conductive contact pad.

According to a third aspect of the disclosure, a manufacturing method of a semiconductor structure is provided, including the following operations.

A substrate in which a conductive connecting line is formed is provided.

A first conductive contact pad and a second conductive contact pad are formed in the substrate. The first conductive contact pad is connected to the conductive connecting line and located above the conductive connecting line. The second conductive contact pad is connected to the conductive connecting line and located above the conductive connecting line.

The first conductive contact pad is spaced apart from the second conductive contact pad.

The semiconductor structure of the disclosure includes a first chip and a second chip. A first conductive connecting line of the first chip connects a first conductive contact pad and a second conductive contact pad. A second conductive connecting line of the second chip connects a third conductive contact pad and a fourth conductive contact pad. The first conductive contact pad and the second conductive contact pad are both in staggered connection with the third conductive contact pad, and are both in staggered connection with the fourth conductive contact pad, so that a reliable electrical connection between the first conductive connecting line and the second conductive connecting line is ensured, the problem of disconnection between the first conductive connecting line and the second conductive connecting line is avoided, and the performance of the semiconductor structure is improved.

### BRIEF DESCRIPTION OF THE DRAWINGS

Various objects, features, and advantages of the disclosure will become more apparent from the following detailed description of preferred implementations of the disclosure when considered in conjunction with the accompanying drawings. The drawings are merely exemplary illustrations of the disclosure and are not necessarily drawn to scale. In the drawings, like reference numerals refer to the same or similar components throughout. In the drawings:
FIG. 1 is a schematic composite structure diagram of a semiconductor structure according to an exemplary implementation.
FIG. 2 is a schematic exploded structure diagram of a semiconductor structure according to an exemplary implementation.
FIG. 3 is a schematic cross-sectional structure diagram of a semiconductor structure according to an exemplary implementation.
FIG. 4 is a schematic connection structure diagram of a part of a semiconductor structure according to an exemplary implementation.
FIG. 5 is another schematic connection structure diagram of a part of a semiconductor structure according to an exemplary implementation.
FIG. 6 is a schematic structure diagram of a semiconductor structure according to an exemplary implementation.
FIG. 7 is a schematic cross-sectional structure diagram of a semiconductor structure according to an exemplary implementation.
FIG. 8 is a schematic flowchart of a manufacturing method of a semiconductor structure according to an exemplary implementation.
FIG. 9 is a schematic structure diagram of forming a conductive connecting line in a manufacturing method of a semiconductor structure according to an exemplary implementation.
FIG. 10 is a schematic structure diagram of forming a second insulating layer in a manufacturing method of a semiconductor structure according to an exemplary implementation.
FIG. 11 is a schematic structure diagram of forming an opening in a manufacturing method of a semiconductor structure according to an exemplary implementation.
FIG. 12 is a schematic structure diagram of forming a conductive contact pad in a manufacturing method of a semiconductor structure according to an exemplary implementation.

Reference numerals are illustrated as follows.
10, Substrate; 11, opening; 12, first insulating layer; 13, second insulating layer; 20, conductive connecting line; 30, first conductive contact pad; 31, second conductive contact pad; 32, support contact pad;
40, First chip; 41, first substrate; 42, first conductive connecting line; 43, first conductive contact pad; 44, second conductive contact pad; 45, first support contact pad; 50, second chip; 51, second substrate; 52, second conductive connecting line; 53, third conductive contact pad; 54, fourth conductive contact pad; 55, second support contact pad.

### DETAILED DESCRIPTION

Exemplary embodiments that embody the features and advantages of the disclosure will be described in detail in the following description. It will be appreciated that the disclosure may have various changes in different embodiments without departing from the scope of the disclosure, and that the description and drawings are illustrative in nature and are not intended to limit the disclosure.

In the following description of various exemplary implementations of the disclosure, reference is made to the accompanying drawings, which form a part thereof, and in which various exemplary structures, systems, and steps capable of implementing various aspects of the disclosure are shown by way of illustration. It will be appreciated that other specific solutions of components, structures, exemplary devices, systems, and steps may be utilized and structural and functional modifications may be made without departing from the scope of the disclosure. Moreover, although the terms "on", "between", "in", etc. may be used in this specification to describe different exemplary features and elements of the disclosure, these terms are used herein for convenience only, e.g., in accordance with the orientation of the examples in the figures. Nothing in this specification should be construed as requiring a particular three-dimensional orientation of the structure to fall within the scope of the disclosure.

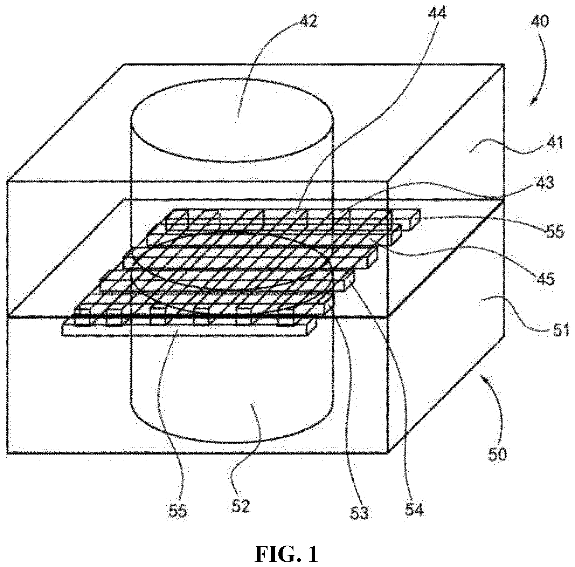

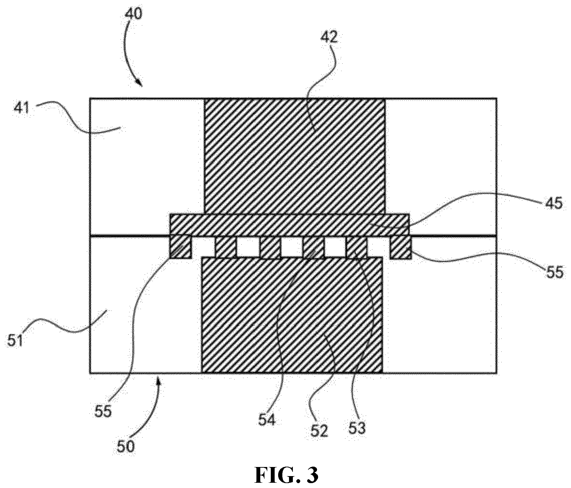

An embodiment of the disclosure provides a semiconductor structure. Referring to FIGS. 1-3, the semiconductor structure includes a first chip 40 and a second chip 50. The first chip 40 includes a first substrate 41, a first conductive connecting line 42, a first conductive contact pad 43, and a second conductive contact pad 44. The first conductive contact pad 43 is spaced apart from the second conductive contact pad 44 and both of the first conductive contact pad 43 and the second conductive contact pad 44 are connected to the first conductive connecting line 42. The second chip 50 includes a second substrate 51, a second conductive connecting line 52, a third conductive contact pad 53, and a fourth conductive contact pad 54. The third conductive contact pad 53 is spaced apart from the fourth conductive contact pad 54 and both of the third conductive contact pad 53 and the fourth conductive contact pad 54 are connected to the second conductive connecting line 52. The first conductive contact pad 43 and the second conductive contact pad 44 are both in staggered connection with the third conductive contact pad 53. The first conductive contact pad 43 and the second conductive contact pad 44 are both in staggered connection with the fourth conductive contact pad 54.

The semiconductor structure of an embodiment of the disclosure includes a first chip 40 and a second chip 50. A first conductive connecting line 42 of the first chip 40 connects a first conductive contact pad 43 and a second conductive contact pad 44. A second conductive connecting line 52 of the second chip 50 connects a third conductive contact pad 53 and a fourth conductive contact pad 54. The first conductive contact pad 43 and the second conductive contact pad 44 are both in staggered connection with the third conductive contact pad 53, and the first conductive contact pad 43 and the second conductive contact pad 44 are both in staggered connection with the fourth conductive contact pad 54, so that a reliable electrical connection between the first conductive connecting line 42 and the second conductive connecting line 52 is ensured, the problem of disconnection between the first conductive connecting line 42 and the second conductive connecting line 52 is avoided, and the performance of the semiconductor structure is improved.

It should be noted that, compared with the related art in which a conductive connecting line between an upper chip and a lower chip which are bonded connects the two chips through a large contact surface, the first conductive contact pad 43 and the second conductive contact pad 44 are both in staggered connection with the third conductive contact pad 53 and the first conductive contact pad 43 and the second conductive contact pad 44 are both in staggered connection with the fourth conductive contact pad 54 in the present embodiment, so that a reliable contact surface can be ensured, and a reliable electrical connection between the first conductive connecting line 42 and the second conductive connecting line 52 is ensured.

In some embodiments, the first conductive connecting line 42, the first conductive contact pad 43, and the second conductive contact pad 44 are all located in the first substrate 41, the second conductive connecting line 52, the third conductive contact pad 53, and the fourth conductive contact pad 54 are all located in the second substrate 51, and the first chip 40 and the second chip 50 are bonded.

It should be noted that the first conductive contact pad 43 and the second conductive contact pad 44 may be located partially in the first substrate 41 or may be located entirely in the first substrate 41. Accordingly, the third conductive contact pad 53 and the fourth conductive contact pad 54 may be located partially in the second substrate 51 or may be located entirely in the second substrate 51.

In some embodiments, the first conductive contact pad 43 and the second conductive contact pad 44 may be located on a surface of the first substrate 41. Accordingly, the third conductive contact pad 53 and the fourth conductive contact pad 54 may be located on a surface of the second substrate 51.

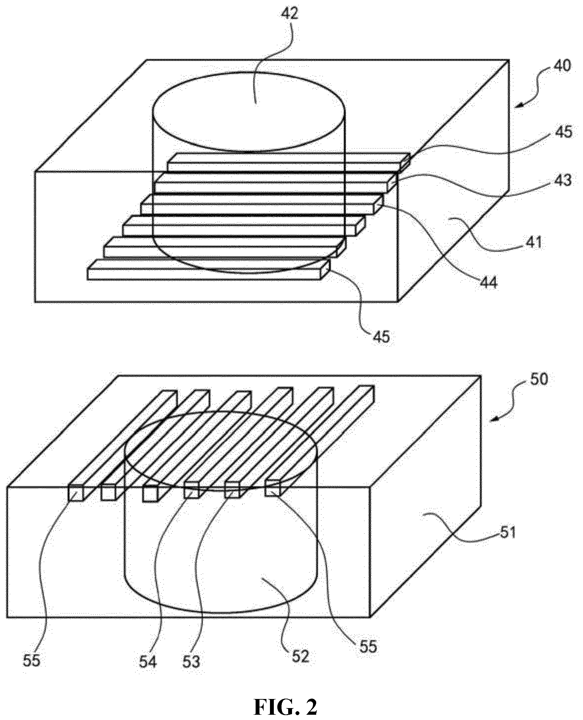

Specifically, as shown in FIGS. 1 and 2, the first chip 40 includes a first substrate 41, a first conductive connecting line 42, a first conductive contact pad 43, and a second conductive contact pad 44. The second chip 50 includes a second substrate 51, a second conductive connecting line 52, a third conductive contact pad 53, and a fourth conductive contact pad 54. After the first chip 40 and the second chip 50 are bonded, the first substrate 41 and the second substrate 51 are bonded, and the first conductive contact pad 43 and the second conductive contact pad 44 are both connected to the third conductive contact pad 53 and the fourth conductive contact pad 54. In some cases, even if misalignment occurs, portions in contact with each other may exist, thereby ensuring a reliable electrical connection between the first conductive connecting line 42 and the second conductive connecting line 52.

In some embodiments, the first conductive contact pad 43 and the second conductive contact pad 44 may be identical structures. The third conductive contact pad 53 and the fourth conductive contact pad 54 may be identical structures.

In some embodiments, the first conductive contact pad 43 and the second conductive contact pad 44 may be different structures. The third conductive contact pad 53 and the fourth conductive contact pad 54 may be different structures.

In some embodiments, at least one of the first conductive contact pad 43 and the second conductive contact pad 44 may be multiple. At least one of the third conductive contact pad 53 and the fourth conductive contact pad 54 may be multiple.

In one embodiment, an extension direction of the first conductive contact pad 43 is consistent with an extension direction of the second conductive contact pad 44. That is, the distance between the first conductive contact pad 43 and the second conductive contact pad 44 is a fixed value.

Accordingly, an extension direction of the third conductive contact pad 53 is consistent with an extension direction of the fourth conductive contact pad 54. That is, the distance between the third conductive contact pad 53 and the fourth conductive contact pad 54 is a fixed value.

In some embodiments, the first conductive contact pad 43 and the second conductive contact pad 44 both extend in a linear direction, and the third conductive contact pad 53 and the fourth conductive contact pad 54 both extend in a linear direction.

In some embodiments, the first conductive contact pad 43 and the second conductive contact pad 44 both extend in a curve direction, and the third conductive contact pad 53 and the fourth conductive contact pad 54 both extend in a curve direction.

In one embodiment, the first conductive contact pad 43 is parallel to the second conductive contact pad 44. That is, the first conductive contact pad 43 and the second conductive contact pad 44 extend in a linear direction, thereby reducing the lengths of the first conductive contact pad 43 and the second conductive contact pad 44.

Accordingly, the third conductive contact pad 53 is parallel to the fourth conductive contact pad 54. That is, the third conductive contact pad 53 and the fourth conductive contact pad 54 extend in a linear direction, thereby reducing the lengths of the third conductive contact pad 53 and the fourth conductive contact pad 54.

In some embodiments, the first conductive contact pad 43 is perpendicular to the third conductive contact pad 53.

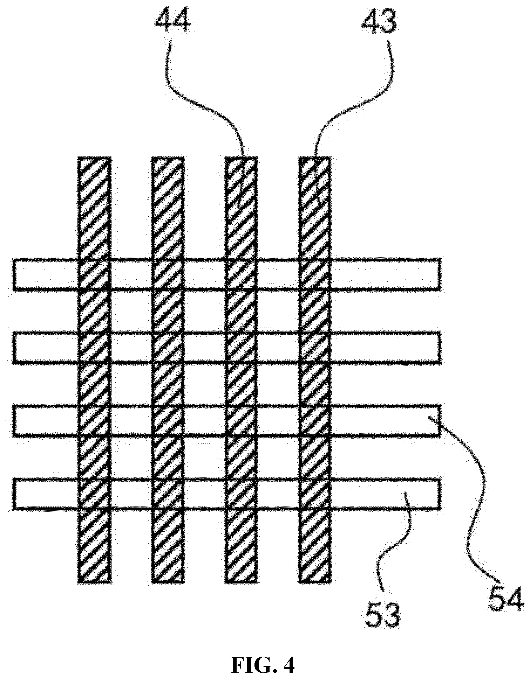

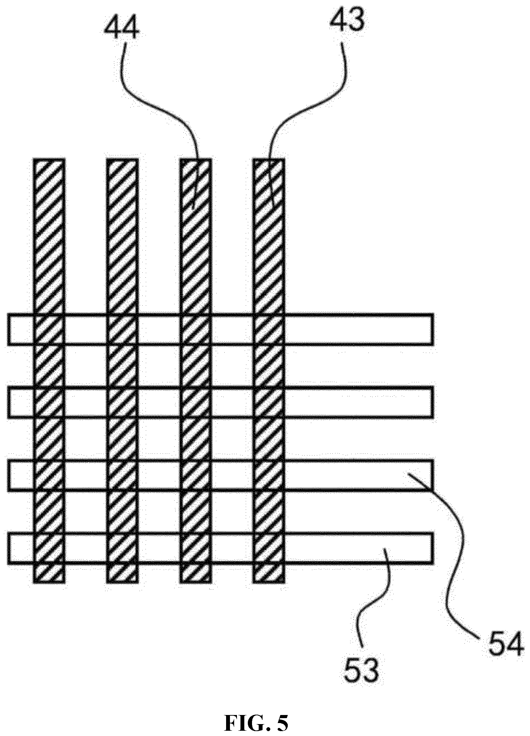

Specifically, as shown in FIG. 4, the first conductive contact pad 43 is parallel to the second conductive contact pad 44, the third conductive contact pad 53 is parallel to the fourth conductive contact pad 54, and the first conductive contact pad 43 is perpendicular to the third conductive contact pad 53. That is, the contact area between the upper and lower contact pads can be minimized, but a stable contact area can be ensured. Even if misalignment bonding occurs, that is, the bonding alignment is poor, the contact area can still be kept unchanged, and the influence on a resistance value of the contact surface is small, as shown in FIG. 5.

In some embodiments, an angle between the first conductive contact pad 43 and the third conductive contact pad 53 may be greater than 0 degrees and less than 180 degrees, i.e., it is ensured that a staggered arrangement may occur, in this case, the contact area between the upper and lower contact pads is larger with respect to the first conductive contact pad 43 being perpendicular to the third conductive contact pad 53.

In one embodiment, as shown in FIGS. 1 and 2, the first chip 40 further includes a first support contact pad 45. The first support contact pad 45 is spaced apart from the first conductive connecting line 42. The first conductive contact pad 43 and the second conductive contact pad 44 are both spaced apart from the first support contact pad 45. The second chip 50 further includes a second support contact pad 55. The second support contact pad 55 is spaced apart from the second conductive connecting line 52. The third conductive contact pad 53 and the fourth conductive contact pad 54 are both spaced apart from the second support contact pad 55. The first support contact pad 45 is in staggered connection with the second support contact pad 55. The arrangement of the first support contact pad 45 and the second support contact pad 55, although electrical connection may not be achieved, can serve for support protection, thereby improving the stability and strength of the semiconductor structure.

Further, the length of the first support contact pad 45 is greater than the diameter of the first conductive connecting line 42. That is, the first support contact pad 45 is not connected to the first conductive connecting line 42, and both ends of the first support contact pad 45 are located at the periphery of the first conductive connecting line 42.

Accordingly, the length of the second support contact pad 55 is greater than the diameter of the second conductive connecting line 52. That is, the second support contact pad 55 is not connected to the second conductive connecting line 52, and both ends of the second support contact pad 55 are located at the periphery of the second conductive connecting line 52.

In some embodiments, the first support contact pad 45 is located in the first substrate 41. The first support contact pad 45 may be located entirely in the first substrate 41, and an upper surface thereof is flush with an upper surface of the first substrate 41, or the first support contact pad 45 may be located partially in the first substrate 41, i.e., the first support contact pad 45 protrudes from the upper surface of the first substrate 41.

Accordingly, the second support contact pad 55 is located in the second substrate 51. The second support contact pad 55 may be located entirely in the second substrate 51, and an upper surface thereof is flush with an upper surface of the second substrate 51, or the second support contact pad 55 may be located partially in the second substrate 51, i.e., the second support contact pad 55 protrudes from the upper surface of the second substrate 51.

In some embodiments, the first support contact pad 45 is located on the upper surface of the first substrate 41 and the second support contact pad 55 is located on the upper surface of the second substrate 51.

In an embodiment, the first support contact pads 45 are arranged in pairs, and the first conductive contact pad 43 and the second conductive contact pad 44 are located between the two first support contact pads 45 in pairs. That is, the outermost two first support contact pads 45 achieve reliable protection.

Accordingly, the second support contact pads 55 are arranged in pairs, and the third conductive contact pad 53 and the fourth conductive contact pad 54 are located between the two second support contact pads 55 in pairs.

In some embodiments, the number of first support contact pads 45 and the number of the second support contact pads 55 may each be greater than two, which is not limited herein.

In some embodiments, an orthographic projection of the first support contact pad 45 in a direction perpendicular to the first substrate 41 coincides with the first conductive connecting line 42. That is, at least part of the first support contact pad 45 may be located directly above the first conductive connecting line 42, but the first support contact pad 45 is spaced apart from the first conductive connecting line 42.

Accordingly, an orthographic projection of the second support contact pad 55 in a direction perpendicular to the second substrate 51 coincides with the second conductive connecting line 52. That is, at least part of the second support contact pad 55 may be located directly above the second conductive connecting line 52, but the second support contact pad 55 is spaced apart from the second conductive connecting line 52.

In some embodiments, an orthographic projection of the first support contact pad 45 in a direction perpendicular to the first substrate 41 does not coincide with the first conductive connecting line 42. That is, the first support contact pad 45 is located in a peripheral region of the first conductive connecting line 42. A lower surface of the first support contact pad 45 may be higher than an upper surface of the first conductive connecting line 42, or the lower surface of the first support contact pad 45 may be equal to the upper surface of the first conductive connecting line 42, or the lower surface of the first support contact pad 45 may be lower than the upper surface of the first conductive connecting line 42.

Accordingly, an orthographic projection of the second support contact pad 55 in a direction perpendicular to the second substrate 51 does not coincide with the second conductive connecting line 52. That is, the second support contact pad 55 is located in a peripheral region of the second conductive connecting line 52. A lower surface of the second support contact pad 55 may be higher than an upper surface of the second conductive connecting line 52, or the lower surface of the second support contact pad 55 may be equal to the upper surface of the second conductive connecting line 52, or the lower surface of the second support contact pad 55 may be lower than the upper surface of the second conductive connecting line 52.

In some embodiments, the space between the first conductive contact pad 43 and the second conductive contact pad 44 is equal to the space between the third conductive contact pad 53 and the fourth conductive contact pad 54.

In some embodiments, the space between the first conductive contact pad 43 and the second conductive contact pad 44 is not equal to the space between the third conductive contact pad 53 and the fourth conductive contact pad 54, thereby ensuring that there is sufficient contact area between the contact pads of the first chip 40 and the second chip 50 even if a bond deviation occurs between the first chip 40 and the second chip 50, and avoiding the problem of disconnection.

In one embodiment, the first conductive connecting line 42 is a first through silicon via, and the second conductive connecting line 52 is a second through silicon via. That is, the first through silicon via and the second through silicon via are connected through mutually staggered contact pads.

In some embodiments, both the length of the first conductive contact pad 43 and the length of the second conductive contact pad 44 are greater than the diameter of the first conductive connecting line 42. That is, both ends of the first conductive contact pad 43 and both ends of the second conductive contact pad 44 may be located outside the first conductive connecting line 42 and not in direct contact with the first conductive connecting line 42.

Accordingly, both the length of the third conductive contact pad 53 and the length of the fourth conductive contact pad 54 are greater than the diameter of the second conductive connecting line 52. That is, both ends of the third conductive contact pad 53 and both ends of the fourth conductive contact pad 54 may be located outside the second conductive connecting line 52 and not in direct contact with the second conductive connecting line 52.

In some embodiments, the first conductive contact pad 43 and the second conductive contact pad 44 may both have rectangular structures, and the third conductive contact pad 53 and the fourth conductive contact pad 54 may both have rectangular structures. The first support contact pad 45 and the second support contact pad 55 may both have rectangular structures.

In some embodiments, the first conductive connecting line 42, the first conductive contact pad 43, and the second conductive contact pad 44 may include copper (Cu), tungsten (W) and other related integrated circuit conductive materials.

Accordingly, the second conductive connecting line 52, the third conductive contact pad 53, and the fourth conductive contact pad 54 may include copper (Cu), tungsten (W) and other related integrated circuit conductive materials. The first support contact pad 45 and the second support contact pad 55 may include copper (Cu), tungsten (W) and other related integrated circuit conductive materials.

In some embodiments, at least one of the first conductive contact pad 43, the second conductive contact pad 44, and the first support contact pad 45 may have a width of 100 nm -1000 nm and a depth of 100 nm -500 nm.

At least one of the third conductive contact pad 53, the fourth conductive contact pad 54, and the second support contact pad 55 may have a width of 100 nm -1000 nm and a depth of 100 nm -500 nm.

In some embodiments, at least one of the first conductive contact pad 43 and the second conductive contact pad 44 may have the same structure as the first support contact pad 45. At least one of the third conductive contact pad 53 and the fourth conductive contact pad 54 may have the same structure as the second support contact pad 55.

In some embodiments, the first conductive contact pad 43 and the second conductive contact pad 44 may both have different structures from the first support contact pad 45. The third conductive contact pad 53 and the fourth conductive contact pad 54 may both have different structures from the second support contact pad 55.

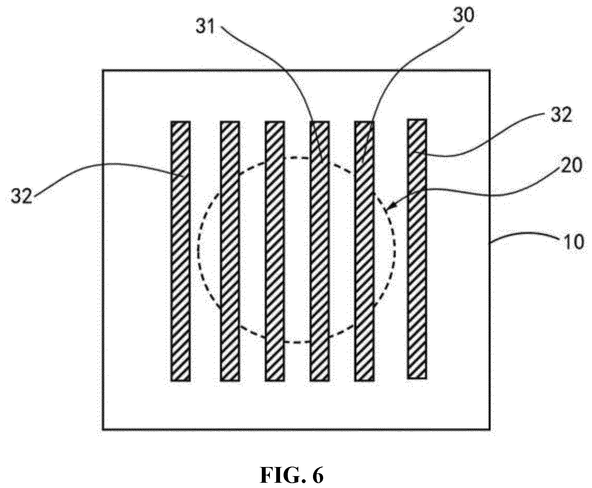

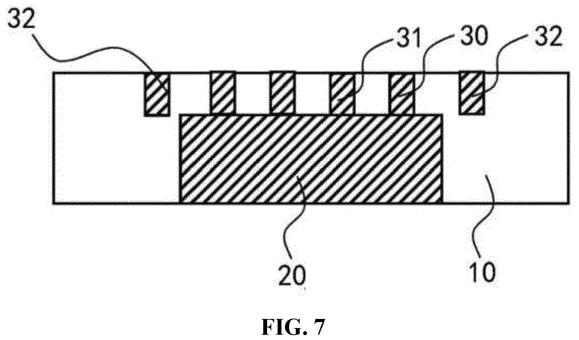

An embodiment of the disclosure also provides a semiconductor structure. Referring to FIGS. 6 and 7, the semiconductor structure includes: a substrate 10; a conductive connecting line 20 located in the substrate 10, a first conductive contact pad 30 located in the substrate 10; and a second conductive contact pad 31 located in the substrate 10. The first conductive contact pad 30 is connected to the conductive connecting line 20 and located above the conductive connecting line 20. The second conductive contact pad 31 is connected to the conductive connecting line 20 and located above the conductive connecting line 20. The first conductive contact pad 30 is spaced apart from the second conductive contact pad 31.

The semiconductor structure of an embodiment of the disclosure includes a substrate 10 and a conductive connecting line 20. A first conductive contact pad 30 and a second conductive contact pad 31 are connected to the conductive connecting line 20. A contact surface of the conductive connecting line 20 for connecting with other conductive structures is changed by arranging the first conductive contact pad 30 and the second conductive contact pad 31 spaced apart from each other, so that the connection reliability of the semiconductor structure is improved, and the conductive connection performance of the semiconductor structure is increased.

It should be noted that the first conductive contact pad 30 is located in the substrate 10. The first conductive contact pad 30 may be located partially in the substrate 10 or may be located entirely in the substrate 10. Accordingly, the second conductive contact pad 31 may be located partially in the substrate 10 or may be located entirely in the substrate 10.

In some embodiments, the first conductive contact pad 30 and the second conductive contact pad 31 may be the same structures.

In some embodiments, the first conductive contact pad 30 and the second conductive contact pad 31 may be different structures.

In some embodiments, at least one of the first conductive contact pad 30 and the second conductive contact pad 31 may be multiple.

In one embodiment, an extension direction of the first conductive contact pad 30 is consistent with an extension direction of the second conductive contact pad 31. That is, the distance between the first conductive contact pad 30 and the second conductive contact pad 31 is a fixed value.

In some embodiments, the first conductive contact pad 30 and the third conductive contact pad 31 both extend in a linear direction.

In some embodiments, the first conductive contact pad 30 and the third conductive contact pad 31 both extend in a curve direction.

In an embodiment, the first conductive contact pad 30 is parallel to the second conductive contact pad 31. That is, the first conductive contact pad 30 and the second conductive contact pad 31 extend in a linear direction, thereby reducing the lengths of the first conductive contact pad 30 and the second conductive contact pad 31.

In one embodiment, as shown in FIGS. 6 and 7, the semiconductor structure further includes a support contact pad 32. The support contact pad 32 is located in the substrate 10. The support contact pad 32 is spaced apart from the conductive connecting line 20. The first conductive contact pad 30 and the second conductive contact pad 31 are both spaced apart from the support contact pad 32. The arrangement of the support contact pad 32, although electrical connection may not be achieved, can serve for support protection, thereby improving the stability and strength of the semiconductor structure.

Further, the length of the support contact pad 32 is greater than the diameter of the conductive connecting line 20. That is, the support contact pad 32 is not connected to the conductive connecting line 20, and both ends of the support contact pad 32 are located at the periphery of the conductive connecting line 20.

In some embodiments, the support contact pad 32 is located in the substrate 10. The support contact pad 32 may be located partially in the substrate 10 or may be located entirely in the substrate 10.

In an embodiment, the support contact pads 32 are arranged in pairs, and the first conductive contact pad 30 and the second conductive contact pad 31 are located between the two support contact pads 32 in pairs. That is, the outermost two support contact pads 32 achieve reliable protection.

In some embodiments, the number of support contact pads 32 may be greater than two, which is not limited herein.

In some embodiments, an orthographic projection of the support contact pad 32 in a direction perpendicular to the substrate 10 coincides with the conductive connecting line 20. That is, at least part of the support contact pad 32 may be located directly above the conductive connecting line 20, but the support contact pad 32 is spaced apart from the conductive connecting line 20.

In some embodiments, an orthographic projection of the support contact pad 32 in a direction perpendicular to the substrate 10 does not coincide with the conductive connecting line 20. That is, the support contact pad 32 may be located in a peripheral region of the conductive connecting line 20, but the support contact pad 32 is spaced apart from the conductive connecting line 20. A lower surface of the support contact pad 32 may be higher than an upper surface of the conductive connecting line 20, or the lower surface of the support contact pad 32 may be equal to the upper surface of the conductive connecting line 20, or the lower surface of the support contact pad 32 may be lower than the upper surface of the conductive connecting line 20.

In an embodiment, the conductive connecting line 20 is a through silicon via.

In some embodiments, both the length of the first conductive contact pad 30 and the length of the second conductive contact pad 31 are greater than the diameter of the conductive connecting line 20. That is, both ends of the first conductive contact pad 30 and both ends of the second conductive contact pad 31 may be located outside the conductive connecting line 20 and not in direct contact with the conductive connecting line 20.

In some embodiments, the first conductive contact pad 30 and the second conductive contact pad 31 may both have rectangular structures, and the support contact pad 32 may have a rectangular structure.

In some embodiments, the first conductive contact pad 30, the second conductive contact pad 31, and the support contact pad 32 may include copper (Cu), tungsten (W) and other related integrated circuit conductive materials.

At least one of the first conductive contact pad 30, the second conductive contact pad 31, and the support contact pad 32 may have a width of 100 nm -1000 nm and a depth of 100 nm -500 nm.

In some embodiments, at least one of the first conductive contact pad 30 and the second conductive contact pad 31 may have the same structure as the support contact pad 32.

In some embodiments, the first conductive contact pad 30 and the second conductive contact pad 31 may both have different structures from the support contact pad 32.

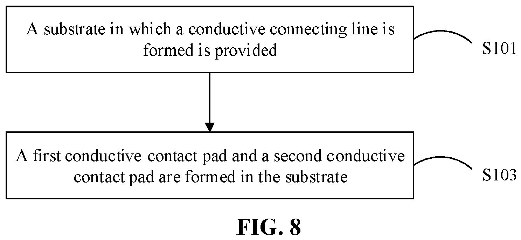

An embodiment of the disclosure also provides a manufacturing method of a semiconductor structure. Referring to FIG. 8, the manufacturing method of the semiconductor structure includes the following operations.

At S101, a substrate 10 in which a conductive connecting line 20 is formed is provided.

At S103, a first conductive contact pad 30 and a second conductive contact pad 31 are formed in the substrate 10. The first conductive contact pad 30 is connected to the conductive connecting line 20 and located above the conductive connecting line 20. The second conductive contact pad 31 is connected to the conductive connecting line 20 and located above the conductive connecting line 20.

The first conductive contact pad 30 is spaced apart from the second conductive contact pad 31.

According to the manufacturing method of the semiconductor structure of an embodiment of the disclosure, a contact surface of the conductive connecting line 20 for connecting with other conductive structures is changed by forming a first conductive contact pad 30 and a second conductive contact pad 31 which are connected to a conductive connecting line 20 and arranging the first conductive contact pad 30 and the second conductive contact pad 31 spaced apart from each other, so that the connection reliability of the semiconductor structure is improved, and the conductive connection performance of the semiconductor structure is increased.

In an embodiment, the substrate 10 includes a silicon substrate and an insulating layer formed above the silicon substrate. An upper portion of the conductive connecting line 20 is located in the insulating layer. The first conductive contact pad 30 and the second conductive contact pad 31 are both formed in the insulating layer. An upper surface of the first conductive contact pad 30 and an upper surface of the second conductive contact pad 31 are both flush with an upper surface of the insulating layer. That is, when used for bonding two wafers, insulating layers of the two wafers are bonded, and corresponding conductive contact pads are bonded.

Specifically, the silicon substrate may be formed of a silicon-containing material. The silicon substrate may be formed of any suitable material, including, e.g., at least one of silicon, monocrystalline silicon, polycrystalline silicon, amorphous silicon, silicon germanium, monocrystalline silicon germanium, polycrystalline silicon germanium, and carbon-doped silicon.

The insulating layer may include silicon dioxide (SiO2), silicon oxycarbide (SiOC), silicon nitride (SiN), silicon carbonitride (SiCN), and other related integrated circuit insulating materials.

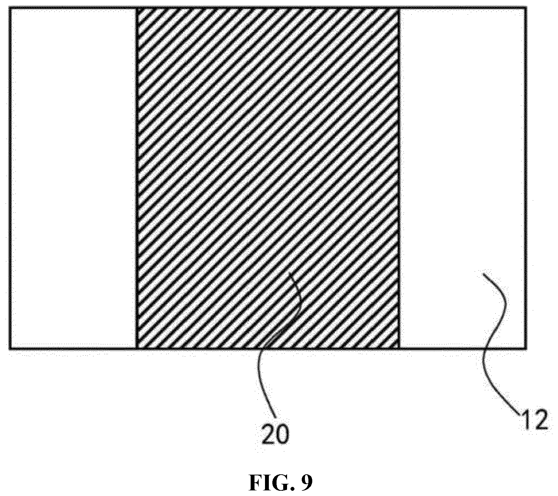

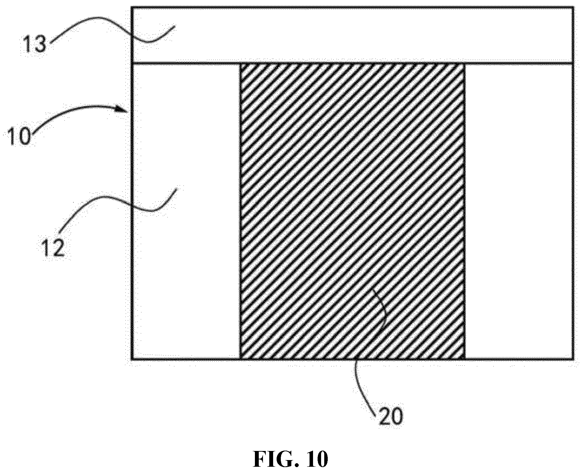

In some embodiments, the insulating layer includes a first insulating layer 12. The upper portion of the conductive connecting line 20 is located in the first insulating layer 12, as shown in FIG. 9, a second insulating layer 13 is formed on the first insulating layer 12, and the second insulating layer 13 covers a top end of the conductive connecting line 20, as shown in FIG. 10.

It should be noted that other conductive structures may be provided in the silicon substrate as well as in the insulating layer, which are not limited herein, and may be selected accordingly according to requirements in the related art.

In an embodiment, after multiple spaced openings 11 are formed in the insulating layer, the first conductive contact pad 30 and the second conductive contact pad 31 are formed in the corresponding openings 11.

In an embodiment, a support contact pad 32 is formed in at least one of the multiple openings 11, and the support contact pad 32 is spaced apart from the conductive connecting line 20.

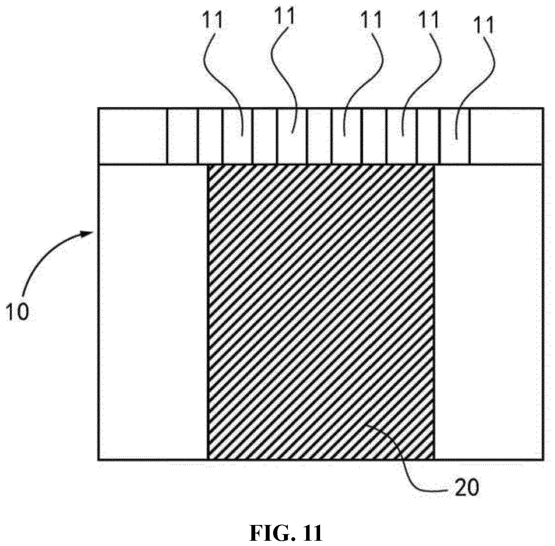

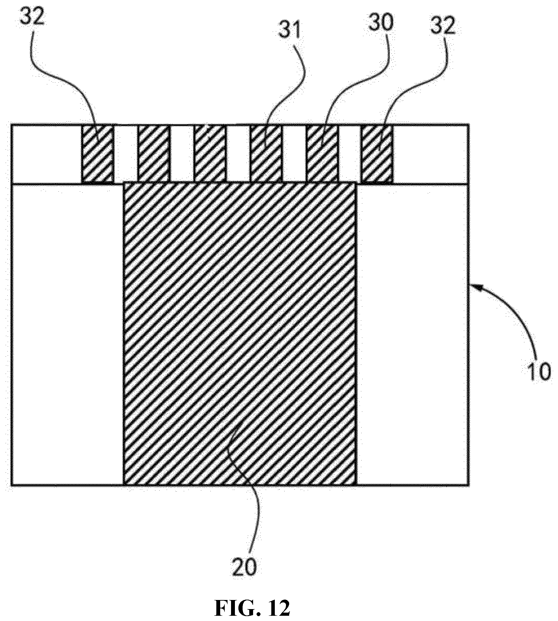

On the basis of FIG. 10, multiple spaced openings 11 are formed in the second insulating layer 13, and the openings 11 penetrate through the second insulating layer 13, as shown in FIG. 11. A first conductive contact pad 30, a second conductive contact pad 31, and a support contact pad 32 are then formed in the multiple openings 11, as shown in FIG. 12.

It should be noted that the second insulating layer 13, the first conductive contact pad 30, the second conductive contact pad 31, and the support contact pad 32 may be formed by a process selected from a Physical Vapor Deposition (PVD) process, a Chemical Vapor Deposition (CVD) process, an Atomic Layer Deposition (ALD) process, an In-Situ Steam Generation (ISSG) process, a Spin On Dielectric (SOD) process, etc. The process is not limited herein.

The formation process of the opening 11 includes photoetching, etching, etc. After each coating is formed, the coating may be treated in conjunction with a Chemical Mechanical Polishing (CMP) process to ensure the flatness of the coating. The first conductive contact pad 30, the second conductive contact pad 31, and the support contact pad 32 may be formed using a plating or sputtering process, which is not limited herein.

In an embodiment, the semiconductor structure may be formed by the above manufacturing method of the semiconductor structure.

After considering the specification and implementing the disclosure disclosed here, other implementation solutions of the disclosure would readily be conceivable to a person skilled in the art. The disclosure is intended to cover any variations, uses, or adaptations of the disclosure following the general principles thereof and including such departures from the disclosure as come within known or customary practice in the art. It is intended that the specification and example implementations be considered as exemplary only, with a true scope and spirit of the disclosure being indicated by the foregoing claims.

It should be understood that the disclosure is not limited to the exact construction that has been described above and illustrated in the accompanying drawings, and that various modifications and changes may be made without departing from the scope thereof. It is intended that the scope of the disclosure only be limited by the appended claims.

## Claims

1. A semiconductor structure, comprising:
a first chip, comprising a first substrate, a first conductive connecting line, a first conductive contact pad, and a second conductive contact pad, the first conductive contact pad being spaced apart from the second conductive contact pad, and both of the first conductive contact pad and the second conductive contact pad being connected to the first conductive connecting line; and
a second chip, comprising a second substrate, a second conductive connecting line, a third conductive contact pad, and a fourth conductive contact pad, the third conductive contact pad being spaced apart from the fourth conductive contact pad, and both of the third conductive contact pad and the fourth conductive contact pad being connected to the second conductive connecting line,
wherein the first conductive contact pad and the second conductive contact pad are both in staggered connection with the third conductive contact pad, and the first conductive contact pad and the second conductive contact pad are both in staggered connection with the fourth conductive contact pad.

2. The semiconductor structure of claim 1, wherein an extension direction of the first conductive contact pad is consistent with an extension direction of the second conductive contact pad; and
an extension direction of the third conductive contact pad is consistent with an extension direction of the fourth conductive contact pad.

3. The semiconductor structure of claim 2, wherein the first conductive contact pad is parallel to the second conductive contact pad; and
the third conductive contact pad is parallel to the fourth conductive contact pad.

4. The semiconductor structure of claim 3, wherein the first conductive contact pad is perpendicular to the third conductive contact pad.

5. The semiconductor structure of claim 1, wherein the first chip further comprises a first support contact pad spaced apart from the first conductive connecting line, the first conductive contact pad and the second conductive contact pad are both spaced apart from the first support contact pad;
the second chip further comprises a second support contact pad spaced apart from the second conductive connecting line, the third conductive contact pad and the fourth conductive contact pad are both spaced apart from the second support contact pad; and
the first support contact pad is in staggered connection with the second support contact pad.

6. The semiconductor structure of claim 5, wherein the first support contact pad is arranged in pairs, and the first conductive contact pad and the second conductive contact pad are located between two first support contact pads in pairs; and
the second support contact pad is arranged in pairs, and the third conductive contact pad and the fourth conductive contact pad are located between two second support contact pads in pairs.

7. The semiconductor structure of claim 5 or 6, wherein an orthographic projection of the first support contact pad in a direction perpendicular to the first substrate is not coincident with the first conductive connecting line; and
an orthographic projection of the second support contact pad in a direction perpendicular to the second substrate is not coincident with the second conductive connecting line.

8. The semiconductor structure of claim 1, wherein a space between the first conductive contact pad and the second conductive contact pad is not equal to a space between the third conductive contact pad and the fourth conductive contact pad.

9. The semiconductor structure of claim 1, wherein the first conductive connecting line is a first through silicon via; and
the second conductive connecting line is a second through silicon via.

10. A semiconductor structure, comprising:
a substrate;
a conductive connecting line, located in the substrate;
a first conductive contact pad, located in the substrate, connected to the conductive connecting line, and located above the conductive connecting line; and
a second conductive contact pad, located in the substrate, connected to the conductive connecting line, and located above the conductive connecting line,
wherein the first conductive contact pad is spaced apart from the second conductive contact pad.

11. The semiconductor structure of claim 10, wherein an extension direction of the first conductive contact pad is consistent with an extension direction of the second conductive contact pad.

12. The semiconductor structure of claim 11, wherein the first conductive contact pad is parallel to the second conductive contact pad.

13. The semiconductor structure of claim 10, further comprising:
a support contact pad, located in the substrate, and spaced apart from the conductive connecting line,
wherein the first conductive contact pad and the second conductive contact pad are both spaced apart from the support contact pad.

14. The semiconductor structure of claim 13, wherein the support contact pad is arranged in pairs, and the first conductive contact pad and the second conductive contact pad are located between two support contact pads in pairs.

15. The semiconductor structure of claim 13 or 14, wherein an orthographic projection of the support contact pad in a direction perpendicular to the substrate is not coincident with the conductive connecting line.

16. The semiconductor structure of claim 10, wherein the conductive connecting line is a through silicon via.

17. A manufacturing method of a semiconductor structure, comprising:
providing a substrate in which a conductive connecting line is formed; and
forming a first conductive contact pad and a second conductive contact pad in the substrate, the first conductive contact pad being connected to the conductive connecting line and located above the conductive connecting line, and the second conductive contact pad being connected to the conductive connecting line and located above the conductive connecting line,
wherein the first conductive contact pad is spaced apart from the second conductive contact pad.

18. The manufacturing method of a semiconductor structure of claim 17, wherein the substrate comprises a silicon substrate and an insulating layer formed above the silicon substrate, an upper portion of the conductive connecting line is located in the insulating layer, the first conductive contact pad and the second conductive contact pad are both formed in the insulating layer, and an upper surface of the first conductive contact pad and an upper surface of the second conductive contact pad are both flush with an upper surface of the insulating layer.

19. The manufacturing method of a semiconductor structure of claim 18, wherein after forming a plurality of spaced openings in the insulating layer, the first conductive contact pad and the second conductive contact pad are formed in respective openings.

20. The manufacturing method of a semiconductor structure of claim 19, wherein a support contact pad is formed in at least one of the plurality of openings, the support contact pad is spaced apart from the conductive connecting line.
